# EUROPEAN PATENT APPLICATION

(11) **EP 4 822 370 A1**
(43) Date of publication of application: **14.10.2026**
(21) Application number: 24900439.1
(22) Date of filing: 20.11.2024
(51) Int. Cl.: G01R 31/392, G01R 31/367, G01R 31/382, G01R 31/387, H01M 10/48, H02J 7/00

(54) **BATTERY ANALYSIS SYSTEM, BATTERY ANALYSIS METHOD, BATTERY ANALYSIS PROGRAM, AND RECORDING MEDIUM**

(30) Priority: 07.12.2023 JP 2023206853
(71) Applicant: Panasonic Intellectual Property Management Co., Ltd., Kadoma-shi, Osaka 571-0057 (JP)
(72) Inventor: SADA Tomokazu, Kadoma-shi, Osaka 571-0057 (JP); TANIKAWA Masahiro, Kadoma-shi, Osaka 571-0057 (JP)
(74) Representative: Novagraaf International SA
(86) International application number: PCT/JP2024/041171
(87) International publication number: WO 2025/121144

(57) **Abstract**

An SOH calculator calculates an SOH based on a current FCC of a secondary battery and an initial FCC of the secondary battery, the current FCC being calculated based on a State of Charge (SOC) difference and an integrated current over a period between a first rest state and a second rest state of the secondary battery, , the SOC difference being determined based on a voltage in the first rest state and a voltage in the second rest state of the secondary battery, which are included in the battery data, and an SOC - Open Circuit Voltage (OCV) curve of the secondary battery. A regression curve generator generates a degradation regression curve of the secondary battery by performing curvilinear regression using sample data of a plurality of the SOHs that have been calculated. The regression curve generator applies, to each of the SOHs, a weight in a range of 0 to 1.

## Description

### TECHNICAL FIELD

The present disclosure relates to a battery analysis system, a battery analysis method, and a battery analysis program for analyzing a battery state, and a recording medium.

### BACKGROUND ART

In recent years, a battery remote monitoring service in which battery data (voltage, current, temperature, etc.) of a battery pack mounted on an EV, a power-assisted bicycle, a PC, or the like is aggregated into a cloud server has been put into practical use. The cloud server that has collected the battery data estimates the battery state (for example, State of Health (SOH) estimation) and detects an abnormal sign (for example, a sign of a micro-short circuit or a cell failure) from use history of the battery, and provides the customer with feedback on an analysis result. In addition, a battery analysis company providing the battery remote monitoring service performs consultation for safe operation, improvement of convenience, lifetime extension, and the like of the battery pack based on the analysis result of the battery pack.

In order to determine the SOH defined by a ratio, to an initial full charge capacity (FCC), of a current FCC of the battery, it is necessary to determine the current FCC. The current FCC is obtained by measuring a discharge capacity until fully discharged from a fully charged state, but few users use the battery until a full discharge state, and it is practically difficult to obtain the FCC by this method.

Therefore, the FCC is often obtained by a two-point open circuit voltage (OCV) method (for example, PTL 1). In the two-point OCV method, the current FCC is estimated based on ΔSOC between a state of charge (SOC) corresponding to an OCV at a first point and a SOC corresponding to an OCV at a second point, and an integrated current during a period between a detection timing of the OCV at the first point and a detection timing of the OCV at the second point. That is, the two-point OCV method is a method of estimating the integrated current corresponding to a SOC 100% change (FCC) based on the integrated current corresponding to the ΔSOC.

### Citation List

### Patent Literature

PTL 1: Unexamined Japanese Patent Publication No. 2008-241358

### SUMMARY OF THE INVENTION

In the two-point OCV method, a calculation error of the SOH tends to be large when the ΔSOC is small. When the ΔSOC is small, an influence of a measurement error of a current sensor or a voltage sensor increases in SOH calculation. When the ΔSOC is small, there is a high possibility that the two OCVs fall within a flat region of a SOC-OCV curve, and when the two OCVs fall within the flat region, an error is likely to occur in conversion from the two OCVs to the ΔSOC.

In order to accurately obtain the ΔSOC, a value of the underlying OCV needs to be accurate, but the relaxation to the OCV after charging or discharging depends on rest time, a temperature, the SOC, a deterioration state, and the like, and the acquisition accuracy of the OCV decreases depending on these conditions.

From the viewpoint of obtaining the integrated current with high accuracy, it is desirable to set two points in the two-point OCV method as a start point and an end point at the time of constant current charging. As a use method of a commercial vehicle, it is common to charge the vehicle once a day, but in the case of a use method of a power-assisted bicycle or a consumer device that is used in a short period of time, many users charge the bicycle or the device once every 3 to 4 days or once a week. Although it is desired to increase opportunities for calculating SOHs in a case where the degradation curve is regressed from sample data of a plurality of SOHs, the number of samples of the SOHs that can be calculated from a charge period is reduced in case of a device with low charging frequencies.

Therefore, it is conceivable to calculate the SOH also from a discharge period, but in the case of a consumer device that is used in a short period of time, the discharge period is often divided into narrow SOC sections. In this case, the ΔSOC in each discharge period decreases, and a calculation error of the SOH tends to increase as described above.

The present disclosure has been made in view of the above circumstances, and it is therefore an object of the present disclosure to provide a technique for improving analysis accuracy regarding the SOH.

In order to solve the above problem, a battery analysis system according to an aspect of the present disclosure includes: a data acquisition unit configured to acquire battery data including a voltage and a current of a secondary battery; a State of Health (SOH) calculator configured to calculate an SOH based on a current Full Charge Capacity (FCC) of the secondary battery and an initial FCC of the secondary battery, the current FCC being calculated based on a State of Charge (SOC) difference and an integrated current over a period between a first rest state and a second rest state of the secondary battery, the SOC difference being determined based on a voltage in the first rest state and a voltage in the second rest state of the secondary battery, which are included in the battery data, and an SOC - Open Circuit Voltage (OCV) curve of the secondary battery; and a regression curve generator configured to generate a degradation regression curve of the secondary battery by performing curvilinear regression using sample data of a plurality of the SOHs that have been calculated, wherein the regression curve generator applies, to each of the SOHs, a weight in a range of 0 to 1.

Note that any combinations of configuration elements described above and expressions of the present disclosure that are converted in terms of devices, systems, methods, programs, recording media, and the like are also effective as aspects of the present disclosure.

According to the present disclosure, it is possible to improve analysis accuracy regarding a SOH.

### BRIEF DESCRIPTION OF THE DRAWINGS

Fig. 1 is a diagram for describing a battery analysis system according to an exemplary embodiment.
Fig. 2 is a diagram showing a configuration example of a battery pack.
Fig. 3 is a diagram showing a configuration example of the battery analysis system according to the exemplary embodiment.
Fig. 4 is a diagram showing a specific image of an estimation method of an FCC.
Fig. 5 is a diagram showing, by a graph, a degradation curve of a secondary battery.
Fig. 6 is a diagram showing an example of a state transition of the battery pack in a predetermined period.
Fig. 7 is a diagram showing an example of a state transition of the battery pack in one charge-discharge cycle.
Fig. 8 is a diagram showing a graph of reliability evaluation of an SOH calculated from battery data of each of three discharge periods that are set in a state transition period of the battery pack shown in Fig. 7.
Fig. 9 is a diagram showing a graph of reliability evaluation of an SOH calculated from battery data of each of six discharge periods that are set in the state transition period of the battery pack shown in Fig. 7.
Fig. 10 is a flowchart showing a flow of battery analysis processing using an SOH by the battery analysis system according to the exemplary embodiment.

### DESCRIPTION OF EMBODIMENT

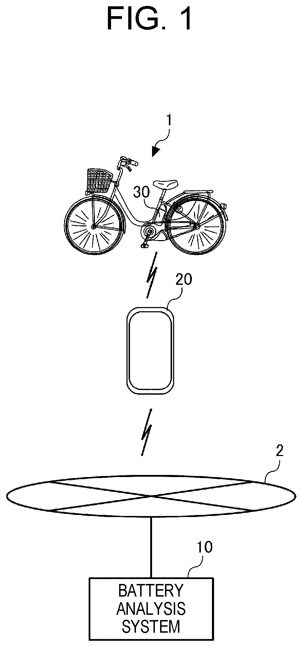

Fig. 1 is a diagram for describing battery analysis system 10 according to an exemplary embodiment. Battery analysis system 10 according to the exemplary embodiment is a system that analyzes battery pack 30 mounted on a battery-mounted device (electric bicycle 1 is assumed in the present exemplary embodiment). For example, battery analysis system 10 may be constructed on an own server installed in an own facility or a data center of a company that provides an analysis service of battery pack 30. Battery analysis system 10 may also be constructed on a cloud server used based on a cloud service. Battery analysis system 10 may also be constructed on a plurality of servers dispersedly installed in a plurality of bases (data center, own facility). The plurality of servers may be a combination of a plurality of own servers, a combination of a plurality of cloud servers, or a combination of own servers and cloud servers.

Electric bicycle 1 is equipped with detachable, portable and replaceable battery pack 30. Battery pack 30 is charged in a state of being mounted into a charging slot of a charger (not illustrated). Battery pack 30 that has been charged is taken out from the charging slot by a user, and is mounted in the mounting slot of electric bicycle 1.

Battery pack 30 and portable communication terminal 20 (hereinafter, a smartphone is assumed) possessed by the user are connected by near field communication. Bluetooth (registered trademark), Wi-Fi (registered trademark), infrared communication, and the like can be used as the near-field communication. Hereinafter, in the present exemplary embodiment, it is assumed that Bluetooth Low Energy (BLE) is used as the near-field communication. The BLE is one of extended standards of Bluetooth, and is a low-power-consumption near-field communication standard using a 2.4 GHz band.

Portable communication terminal 20 can access network 2 to which battery analysis system 10 is connected. Portable communication terminal 20 can access network 2 via a mobile phone network (4G/5G) or a wireless LAN.

Network 2 is a general term for communication paths such as the Internet, a dedicated line, and a virtual private network (VPN), and a communication medium and a protocol thereof are not limited. Available examples of the communication medium include a wired LAN, a wireless LAN, a mobile phone network, an optical fiber network, an ADSL network, and a CATV network. Available examples of the communication protocol include transmission control protocol (TCP)/internet protocol (IP), user datagram protocol (UDP)/IP, and Ethernet (registered trademark).

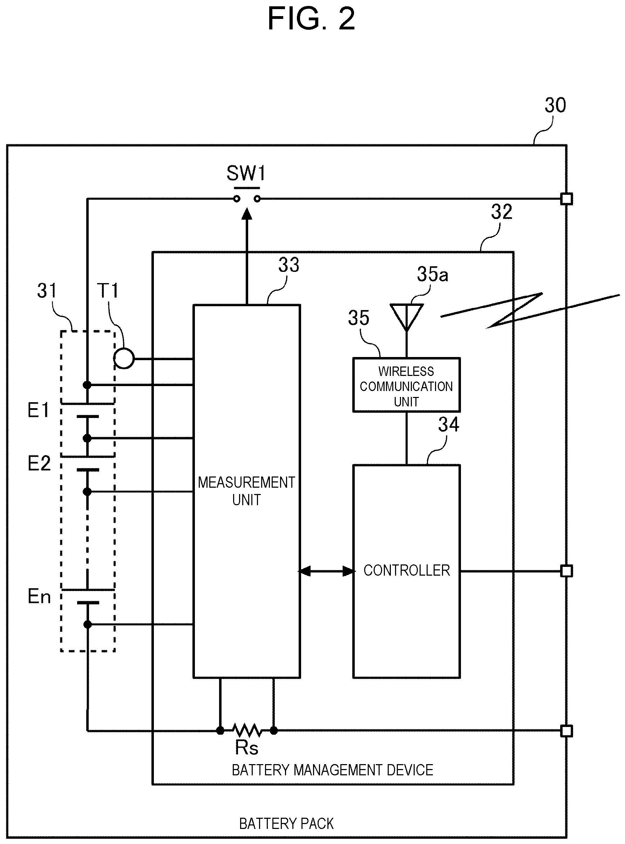

Fig. 2 is a diagram showing a configuration example of battery pack 30. Battery pack 30 includes assembled battery 31 and battery management device 32. Assembled battery 31 includes a plurality of cells E1-En connected in series. The number of cells in series is determined by the specification of a load. Main loads of electric bicycle 1 are a motor and an inverter.

Available examples of the cell include a lithium-ion battery cell, a nickel-metal-hydride battery cell, and a lead battery cell. Hereinafter, the present description assumes an example of use of lithium-ion battery cells (nominal voltage: 3.6 V to 3.7 V). Note that, in the series stage of each cell, a plurality of cells may be connected in parallel in order to increase the capacity.

Switch SW1 for switching conduction/non-conduction with the load or the charger is inserted into a power line connecting assembled battery 31 and a load or the charger. A semiconductor switch or a relay can be used as switch SW1.

Battery management device 32 includes measurement unit 33, controller 34, wireless communication unit 35, and antenna 35a. Measurement unit 33 includes an analog front end (AFE) IC or an application specific integrated circuit (ASIC). Controller 34 includes a microcontroller.

Measurement unit 33 is connected to each node of the plurality of series-connected cells E1-En with a plurality of voltage measurement lines and measures a voltage of each of cells E1-En by measuring each voltage between neighboring two voltage lines.

Measurement unit 33 includes a multiplexer and an A/D converter. The multiplexer outputs respective voltages of the plurality of cells E1-En to the A/D converter in given order. The A/D converter converts, into a digital value, an analog voltage to be input from the multiplexer. Measurement unit 33 transmits the voltage value of each of cells E1-En converted into the digital value to controller 34 via a serial communication interface.

Measurement unit 33 measures the current flowing through assembled battery 31. Shunt resistor Rs is connected to a power line connecting assembled battery 31 and the load or the charger. The differential amplifier (not illustrated) amplifies the voltage across shunt resistor Rs and outputs the amplified voltage to the A/D converter in measurement unit 33. The A/D converter converts an analog voltage, which is input from the differential amplifier and indicates a current flowing through assembled battery 31, into a digital value. Measurement unit 33 transmits the current value converted into the digital value to controller 34 via the serial communication interface.

Temperature sensor T1 (for example, a thermistor) is installed on the surface of assembled battery 31. A divided voltage of temperature sensor T1 and a voltage-dividing resistor (not illustrated) is input to measurement unit 33. The A/D converter in measurement unit 33 converts an analog voltage indicating an input temperature into a digital value. Measurement unit 33 transmits the temperature value converted into the digital value to controller 34 via the serial communication interface.

Controller 34 manages the states of cells E1-En based on the voltage value of each of cells E1-En, the current value flowing through assembled battery 31, and the temperature value of assembled battery 31 that have been received from measurement unit 33. When detecting any one of overcharge, overdischarge, overcurrent, high-temperature abnormality, and low-temperature abnormality, controller 34 transmits a shut-off signal of switch SW1 to measurement unit 33 to turn off switch SW1.

Controller 34 estimates the SOC by combining an OCV method and a coulomb counting method. The OCV method is a method of estimating the SOC based on the OCV based on a voltage of a cell to be measured and an SOC-OCV curve of the cell. The SOC-OCV curve of the cell is created in advance based on a characteristic test performed by a battery manufacturer, and is registered in controller 34 at the time of shipment.

The coulomb counting method is a method of estimating the SOC based on the OCV at the start of charging and discharging of a cell and an integrated value of a measured current. The coulomb counting method causes a measurement error of the current to accumulate as charging and discharging time increases. Thus, it is preferable to use a weighted average of the SOC estimated by the coulomb counting method and the SOC estimated by the OCV method.

Controller 34 transmits battery data including a voltage, a current, a temperature, and an SOC of each cell of battery pack 30 to wireless communication unit 35. Wireless communication unit 35 executes signal processing of near field communication. Wireless communication unit 35 is paired with portable communication terminal 20, and transmits the battery data received from controller 34 to portable communication terminal 20 by near field communication. Wireless communication unit 35 transmits the battery data to portable communication terminal 20 at a predetermined transmission cycle (for example, one minute cycle).

Portable communication terminal 20 accesses network 2 and transfers the battery data received from battery pack 30 to battery analysis system 10 in real time. Alternatively, portable communication terminal 20 temporarily stores, in an internal buffer, the battery data received from battery pack 30, and batch transmits the stored battery data to battery analysis system 10.

When wireless communication unit 35 of battery pack 30 includes a module for connecting to a mobile phone network (4G/5G), wireless communication unit 35 can directly access network 2 without passing through the portable communication terminal 20, and transmit the battery data to battery analysis system 10.

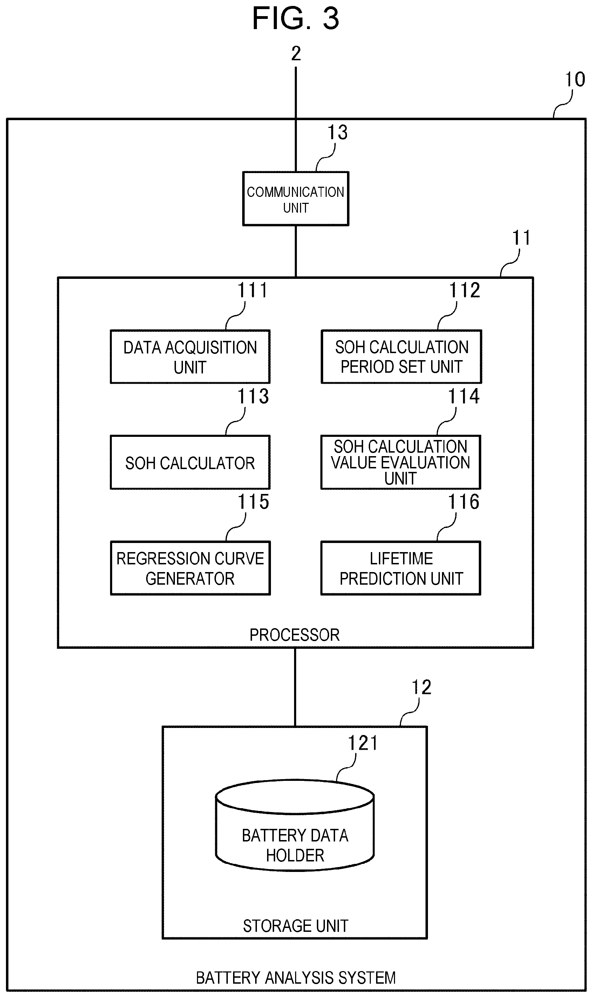

Fig. 3 is a diagram showing a configuration example of battery analysis system 10 according to the exemplary embodiment. Battery analysis system 10 includes controller 11, storage unit 12, and communication unit 13. Communication unit 13 is an external communication interface (for example, NIC: network interface card) for connection to network 2 in a wired manner or a wireless manner.

Controller 11 includes data acquisition unit 111, SOH calculation period set unit 112, SOH calculator 113, SOH calculation value evaluation unit 114, regression curve generator 115, and lifetime prediction unit 116. Functions of controller 11 can be achieved by cooperation of a hardware resource and a software resource, or by a hardware resource alone. As the hardware resources, a CPU, a ROM, a RAM, a GPU, an ASIC, an FPGA, and other LSIs can be used. Available examples of the software resource include a program, such as an operating system or an application. The program may be recorded in a recording medium. When this recording medium is used, the program can be installed in the computer, for example. Here, the recording medium on which the program is recorded may be a non-transitory recording medium. Although the non-transitory recording medium is not particularly limited, it may be a recording medium such as a CD-ROM, for example.

Storage unit 12 includes a nonvolatile recording medium such as an HDD or an SSD, and stores various kinds of data. Storage unit 12 includes battery data holder 121. Data acquisition unit 111 acquires the battery data of battery pack 30 via network 2. Data acquisition unit 111 stores the acquired battery data in battery data holder 121.

SOH calculator 113 calculates the SOH of each cell or assembled battery 31 as a whole using a two-point OCV method. When calculating the SOH of the entire assembled battery 31, SOH calculator 113 adds up the cell voltages of the plurality of cells E1-En connected in series, the cell voltages being included in the battery data, to calculate the voltage of assembled battery 31.

SOH calculator 113 obtains an SOC difference (ΔSOC) between the SOC in the first rest state and the SOC in the second rest state based on a voltage in a first rest state of the cell or assembled battery 31, a voltage in a second rest state of the cell or assembled battery 31, and a SOC-OCV curve of the cell or assembled battery 31. SOH calculator 113 obtains integrated current Q during a period between the first rest state and the second rest state based on a value of the current included in the battery data. SOH calculator 113 obtains a current FCC of the cell or assembled battery 31 based on integrated current Q and the ΔSOC. SOH calculator 113 calculates a SOH based on the current FCC and an initial FCC of the cell or assembled battery 31.

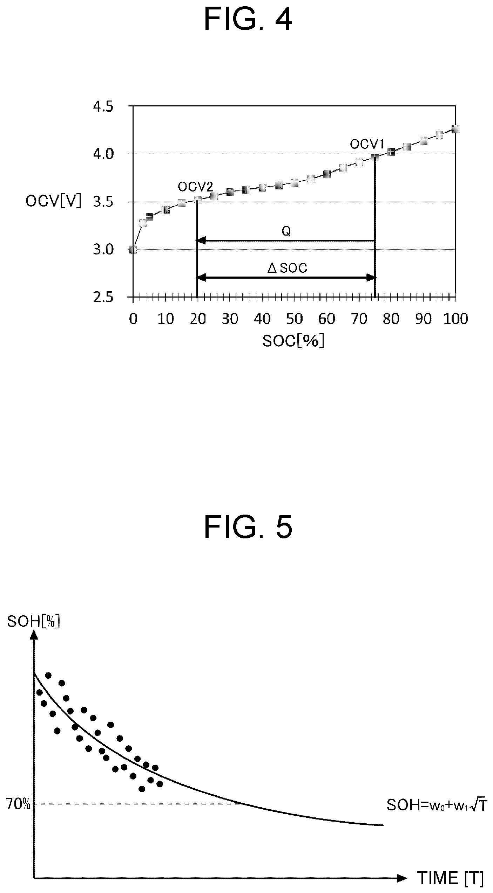

Fig. 4 is a diagram showing a specific image of an estimation method of the FCC. SOH calculator 113 specifies voltages at two points of the first rest state and the second rest state, and sets the voltages as OCVs at the two points. SOH calculator 113 refers to the SOC-OCV curve, specifies SOCs at the two points respectively corresponding to the OCVs at the two points, and calculates a ΔSOC between the SOCs at the two points. In the example illustrated in Fig. 4, the SOCs at the two points are 20% and 75%, and the ΔSOC is 55%.

SOH calculator 113 calculates integrated current amount (= discharge and charge capacity) Q between the times of the two points at which the two OCVs are acquired. SOH calculator 113 estimates the FCC by calculating the following (Equation 1).$FCC = Q / ΔSOC$ (Equation 1)

The SOH is defined as a ratio of the current FCC to the initial FCC, and a lower value (closer to 0%) indicates that deterioration has progressed more. SOH calculator 113 estimates the SOH by calculating the following (Equation 2).$SOH = Current FCC / Initial FCC \times 100$ (Equation 2)

Regression curve generator 115 generates a degradation regression curve of the cell or assembled battery 31 by performing curvilinear regression using sample data of a plurality of SOHs that have been calculated in a time series for the cell or assembled battery 31. For example, a least squares method can be used for curvilinear regression.

Fig. 5 is a diagram showing, by a graph, a degradation curve of the secondary battery. It is known that degradation of a cell progresses in proportion to a square root of time (0.5 power law), as shown by the following (Equation 3).$SOH = w 0 + w 1 √ t$ (Equation 3)

Here, w0 is an initial value, and w1 is a degradation coefficient.

Regression curve generator 115 obtains degradation coefficient w1 in the above (Equation 3) based on exponential curvilinear regression of 0.5 power taking time t as an independent variable and the SOH as a dependent variable. Initial value w0 is common and is usually set in a range from 1.0 to 1.1 inclusive. When actual initial capacity coincides with a nominal value, w0 is set to 1.0. When the nominal value is set to a minimum guaranteed amount and is set lower than the actual initial capacity, w0 is set to a value greater than 1.0.

Lifetime prediction unit 116 can, by substituting an SOH at which the use of battery pack 30 is stopped (70% in the example of Fig. 5) into the generated degradation regression curve, predict a period until the curve reaches the SOH at which the use is stopped (remaining lifetime). Here, a value of the SOH at any future date and time can be predicted by substituting the any future date and time into the degradation regression curve.

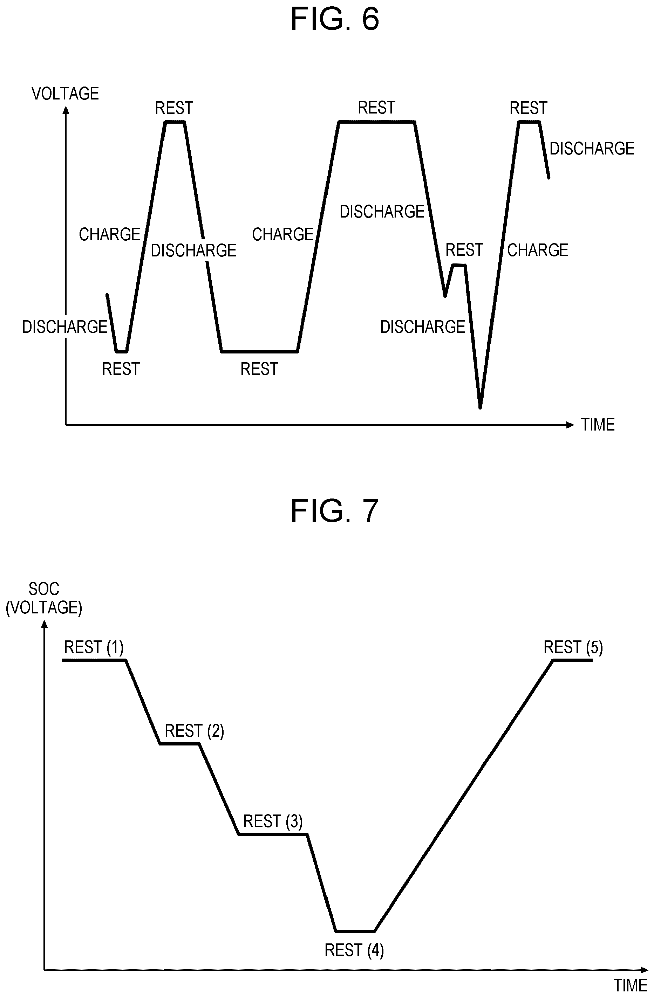

Fig. 6 is a diagram showing an example of a state transition of battery pack 30 in a predetermined period. The state transition of battery pack 30 is classified into a charge period, a discharge period, and a reset period. The voltage and the SOC of battery pack 30 increase in the charge period, the voltage and the SOC decrease in the discharge period, and the voltage and the SOC are maintained to be constant in principle in the reset period. The state of battery pack 30 can be determined based on whether the value of the current included in the battery data is "positive", "negative", or "0".

Empirical data shows that many users use a capacity of about 10% to 15% DOD of battery pack 30 mounted on electric bicycle 1 per day, and charge the battery pack at once over the weekend. In this case, the discharge periods are generated stepwise, and the length of each discharge period is short. The charge period occurs once a week, and the length of one charge period becomes long. The same tendency is observed in other consumer devices, and basically, there is a tendency that in the discharge period, an appearance frequency is high and a length of one period is short, and in the charge period, an appearance frequency is low and a length of one period is long.

Fig. 7 is a diagram showing an example of a state transition of battery pack 30 in one charge-discharge cycle. Basically, it is desirable that the SOH is calculated based on the battery data of the charge period in which the current value is stable, but this decreases the opportunity for calculation of the SOH. In order to generate the degradation regression curve of the secondary battery as described above, sample data of at least about 25 to 40 SOHs is usually required. When the SOH is calculated only from the charge period, it takes time from the start of operation of battery pack 30 until the degradation regression curve is first generated. In addition, during the operation of battery pack 30, it takes time until the deterioration phenomenon actually occurring in the secondary battery is reflected in the degradation regression curve.

Therefore, it is conceivable to calculate the SOH also from the battery data of the discharge period. However, the current value in the discharge period irregularly changes, unlike the current value in the charge period based on CC-CV charging. In addition, since the battery data is discrete data, it is handled that a current value at a certain sampling timing basically is kept to be the same until the next sampling timing comes. In a case where the current value at the sampling timing is accidentally an outlier, an error of the integrated current increases. Such an error of the integrated current at the time of discharge increases as the sampling period becomes longer.

As described above, SOH calculation accuracy based on the battery data of the discharge period tends to be lower than the SOH calculation accuracy based on the battery data of the charge period, and it is necessary to pay attention to the SOH calculation accuracy based on the battery data of the discharge period.

In general, factors that greatly affect the SOH calculation accuracy include (1) ΔSOC, (2) a length of rest time, (3) a temperature during rest, and (4) a slope of the SOC-OCV curve.

In general, the larger the ΔSOC is, the higher the SOH calculation accuracy is. When the ΔSOC is small, values of the numerator and the denominator in the above (Equation 1) are small. The weight of the current value and the voltage value of one sample increases, and an influence of a measurement error of a current sensor or a voltage sensor on the values of the numerator or the denominator of the above (Equation 1) increases. Actually, it is difficult to suppress the measurement error of the current sensor or the voltage sensor to zero. When the ΔSOC is small, there is a high possibility that the two OCVs fall within a flat region of a SOC-OCV curve, and when the two OCVs fall within the flat region, an error is likely to occur in conversion from the two OCVs to the ΔSOC.

On the other hand, when the ΔSOC is large, a variation in the current value due to the measurement error of the current sensor or the like is smoothed by integration for a long period of time. As described above, it can be said that the reliability of the SOH calculated from the battery data of the range in which the ΔSOC is small is low, and the reliability of the SOH calculated from the battery data of the range in which the ΔSOC is large is high.

The voltage value included in the battery data is a measurement value of a voltage across both ends of each of the cells E1-En. The secondary battery is an electrochemical product, in which a measured voltage rises nonlinearly when a charging current flows through the secondary battery, and the measured voltage drops nonlinearly when a discharging current flows through the secondary battery. A voltage measured when a current flows through the secondary battery is referred to as a closed circuit voltage (CCV) or an operating voltage. After completion of charging and discharging, the secondary battery converges (relaxes), over time, to an OCV not containing an overvoltage component.

The convergence time to the OCV depends on a cell type, a temperature, a SOH, and the like. In recent years, lithium ion battery cells using a negative electrode material mixed with silicon have been developed. In the lithium-ion battery cell, polarization elimination time is longer than that of a general cell, and it takes 1 hour to 10 hours or more to converge to OCV after the end of charging and discharging. In addition, in a low temperature environment, a chemical reaction rate in the cell becomes slow, and it takes a long time for convergence to the OCV. In addition, in the case of a degraded cell with a reduced SOH, it takes a long time for convergence to the OCV.

From the above findings, there is a high possibility that the voltage measured in a state where the rest time continues for a long time coincides with the OCV, and there is a high possibility that the voltage measured in a state where the rest time is short deviates from the OCV. Further, among the voltages measured in the rest state, there is a high possibility that the voltage measured in a high temperature state coincides with the OCV, and there is a high possibility that the voltage measured in a low temperature state deviates from the OCV. In addition, among the voltages measured in the rest state, there is a high possibility that the voltage of a cell having a high SOH coincides with the OCV, and there is a high possibility that the voltage of a cell having a low SOH deviates from the OCV.

An SOC-OCV curve of a cell depends on the type of the cell. The SOC-OCV curves of some cells have a flat region. The flat region of the SOC-OCV curve is a region where the SOC hardly changes with respect to the change of the OCV, and an error is likely to occur when the OCVs at the two points are converted into the ΔSOC corresponding to the SOC change amount. A slight error in the measurement voltage leads to large misreading of the SOC.

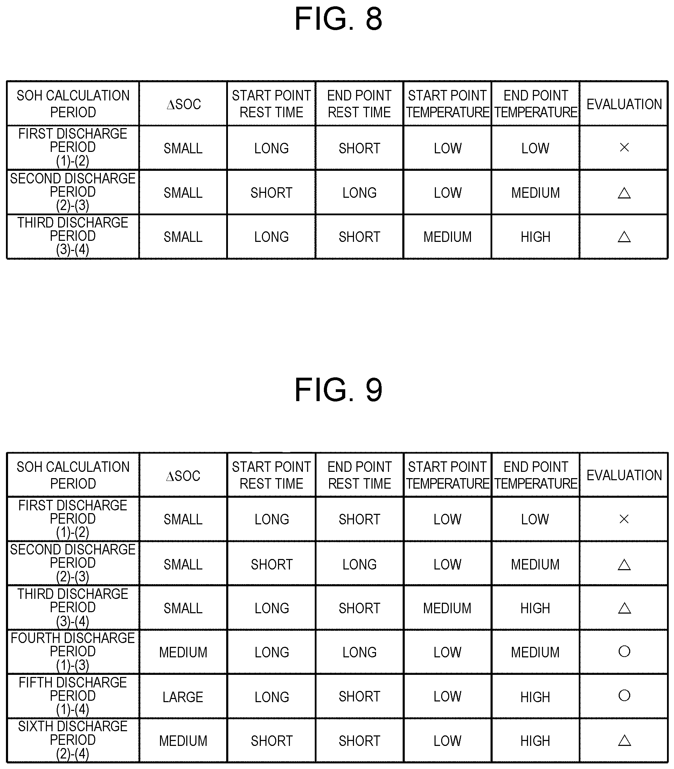

Fig. 8 is a diagram showing a graph of reliability evaluation of an SOH calculated from battery data of each of three discharge periods that are set in a state transition period of battery pack 30 shown in Fig. 7. SOH calculation period set unit 112 sets a first discharge period between a first reset period (1) and a second reset period (2), a second discharge period between the second reset period (2) and a third reset period (3), and a third discharge period between the third reset period (3) and a fourth reset period (4).

SOH calculator 113 calculates an SOH based on battery data of each discharge period. SOH calculation value evaluation unit 114 evaluates reliability of each SOH. In the example shown in Fig. 8, five items of (1) ΔSOC, (2) a length of rest time at a start point, (3) a length of rest time at an end point, (4) a temperature at the start of discharge, and (5) a temperature at the end of discharge are evaluated as evaluation items of SOH.

SOH calculation value evaluation unit 114 increases an evaluation score as a value of the ΔSOC increases. In the example shown in Fig. 8, values of the ΔSOC are classified into three groups of "small", "medium", and "large", and SOH calculation value evaluation unit 114 evaluates the evaluation score as "low" when the value of the ΔSOC is "small", as "medium" when the value of the ΔSOC is "medium", and as "high" when the value of the ΔSOC is "large". Note that SOH calculation value evaluation unit 114 may not perform evaluation in three stages, and may perform evaluation in two stages or in four or more stages. Here, instead of classifying evaluation scores, a normalized numerical value itself may be used for comprehensive evaluation described later.

SOH calculation value evaluation unit 114 increases the evaluation score as the length of the rest time at the start point becomes longer. In the example shown in Fig. 8, lengths of the rest time at the start point are classified into three groups of "short", "medium", and "long", and SOH calculation value evaluation unit 114 evaluates the evaluation score as "low" when the length of the rest time at the start point is "short", "medium" when the length of the rest time is "medium", and "high" when the length of the rest time is "long".

SOH calculation value evaluation unit 114 increases the evaluation score as the length of the rest time at the end point becomes longer. In the example shown in Fig. 8, lengths of the rest time at the end point are classified into three groups of "short", "medium", and "long", and SOH calculation value evaluation unit 114 evaluates the evaluation score as "low" when the length of the rest time at the end point is "short", "medium" when the length of the rest time is "medium", and "high" when the length of the rest time is "long".

SOH calculation value evaluation unit 114 increases the evaluation score as the temperature at the start of discharge becomes higher. In the example shown in Fig. 8, temperatures at the start of discharge are classified into three groups of "low", "medium", and "high", and SOH calculation value evaluation unit 114 evaluates the evaluation score as "low" when the temperature at the start of discharge is "low", "medium" when the temperature is "medium", and "high" when the temperature is "high".

SOH calculation value evaluation unit 114 increases the evaluation score as the temperature at the end of discharge becomes higher. In the example shown in Fig. 8, temperatures at the end of discharge are classified into three groups of "low", "medium", and "high", and SOH calculation value evaluation unit 114 evaluates the evaluation score as "low" when the temperature at the end of discharge is "low", "medium" when the temperature is "medium", and "high" when the temperature is "high".

SOH calculation value evaluation unit 114 calculates a total evaluation score by summing the evaluation scores of all the five items. In the example shown in Fig. 8, SOH calculation value evaluation unit 114 classifies total evaluation scores into three groups of "×(Unsucessful)", "△(Fair)", and "○(Successful)".

Regression curve generator 115 can weight the sample data of each SOH in a range of 0 to 1. Specifically, regression curve generator 115 places a larger weight on sample data of an SOH having a higher total evaluation score. For example, regression curve generator 115 may set such that the weight of the evaluation score "○" is 1.0, the weight of the evaluation score "△" is 0.5, and the weight of the evaluation score "×" is 0.2. Note that the weight of "×" may be set to 0.0. In this case, the sample having the evaluation score of "×" is excluded from basic data of the regression curve generation.

After weighting each of pieces of the sample data of n SOHs, regression curve generator 115 performs weighted curvilinear regression using the sample data of the n SOHs. The following (Equation 4) is a normal regression, and regression curve generator 115 derives degradation coefficient w1 of the above (Equation 3) so that sum of squares E of residual εi of each of pieces of the sample data is minimized.$E = Σεi 2 \left(i=1 to n\right)$ (Equation 4)

The following (Equation 5) is a weighted regression, and regression curve generator 115 derives degradation coefficient w1 of the above (Equation 3) so that sum E of values obtained by multiplying the square of residual εi of pieces of the sample data by weight wei is minimized.$E = Σweiεi 2 \left(i=1 to n\right)$ (Equation 5)

Fig. 9 is a diagram showing a graph of reliability evaluation of an SOH calculated from battery data of each of six discharge periods that are set in the state transition period of battery pack 30 shown in Fig. 7. The discharge period shown in Fig. 8 is obtained by extracting only a section including one continuous discharge period without a rest period being interposed. On the other hand, in the discharge period shown in Fig. 9, interposition of at least one rest period is allowed, and a period including a plurality of discharge periods and at least one rest period is extracted as well.

In addition to the three discharge periods shown in Fig. 8, SOH calculation period set unit 112 sets a fourth discharge period between the first reset period (1) and the third reset period (3), a fifth discharge period between the first reset period (1) and the fourth reset period (4), and a sixth discharge period between the second reset period (2) and the fourth reset period (4).

In the examples of Figs. 8 and 9, the values of the ΔSOC in the first discharge period, the second discharge period, and the third discharge period are all classified as "small", but the values of the ΔSOC in the fourth discharge period and the sixth discharge period are classified as "medium", and the value of the ΔSOC in the fifth discharge period is classified as "large". As described above, SOH calculation value evaluation unit 114 increases the evaluation score as the value of ΔSOC increases. Therefore, the larger the value of ΔSOC is, the higher the overall evaluation score is likely to be.

Since an internal resistance of the battery increases and the temperature of battery pack 30 increases as the battery is discharged to low SOC, the temperatures at the end of discharge in the third discharge period, the fifth discharge period, and the sixth discharge period are classified as "high". As described above, SOH calculation value evaluation unit 114 increases the evaluation score as the temperature at the end of discharge becomes higher. Therefore, the higher the temperature at the end of discharge is, the higher the overall evaluation score is likely to be.

From the above viewpoint, in the example shown in Fig. 9, SOH calculation value evaluation unit 114 evaluates the total evaluation scores of the fourth discharge period and the fifth discharge period as "○". Note that the five evaluation items of the SOH shown in Figs. 8 and 9 are examples, and the use SOC range, a current level of the SOH, and the like may be added to the evaluation items. SOH calculation value evaluation unit 114 increases the evaluation score as a slope of the use SOC range in the SOC-OCV curve becomes steeper. SOH calculation value evaluation unit 114 increases the evaluation score as the current level of the SOH becomes higher. As a result, it is possible to prevent the SOH sample data from being unnecessarily excluded from the basic data of the regression curve generation, and the weighted curvilinear regression is more easily performed.

In addition, the evaluation items of the SOH may be reduced for simplification. For example, when temperature data is not acquired, (4) the temperature at the start of discharge and (5) the temperature at the end of discharge are excluded from the evaluation items.

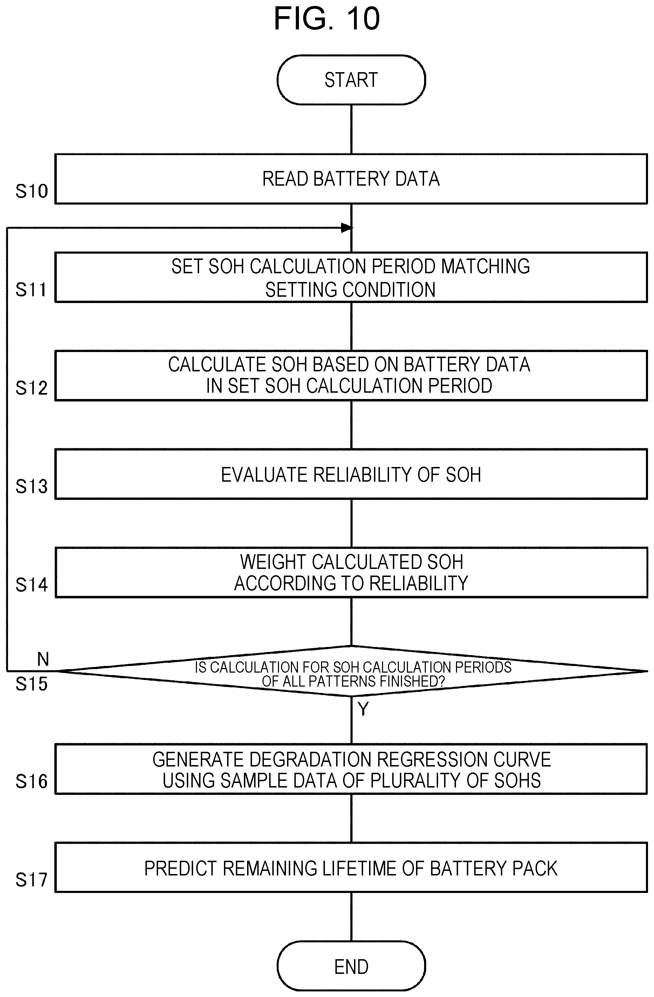

Fig. 10 is a flowchart showing a flow of battery analysis processing using an SOH by battery analysis system 10 according to the exemplary embodiment. SOH calculator 113 reads time-series battery data of the cells or assembled battery 31 included in battery pack 30 to be analyzed, the time-series battery data being accumulated in battery data holder 121 (S10). SOH calculation period set unit 112 sets the SOH calculation period meeting a setting condition for thetime-series battery data (S11).

As the setting condition, it is possible to select only the charge period, only the discharge period, or both the charge period and the discharge period. As the discharge period, "only a discharge period without a rest period being interposed" and "a discharge period including a plurality of discharge periods between which a rest period is interposed" can be selected. In order to suppress an increase in the number of combinations of the discharge period, it is possible to adopt a specification in which an upper limit can be set to the number of rest periods interposed or the entire period of the discharge period. When the upper limit is set to the entire period of the discharge period, the calculation of the SOH based on the battery data in the SOH calculation period longer than the upper limit is skipped. As a result, it is possible to suppress an integration error due to an increase in the SOH calculation period, and to further improve the analysis accuracy regarding the SOH.

Similarly, for the charge period, it is possible to adopt a specification in which "only a charge period without a rest period being interposed" or "a charge period including a plurality of charging periods between which a rest period is interposed" can be selected.

In addition, when both the charge period and the discharge period are selected as the SOH calculation section, it is possible to adopt a specification in which a charge-discharge period can be selected as the SOH calculation period. The charge-discharge period includes at least one charge period, at least one discharge period, and at least one rest period interposed therebetween. In order to suppress an increase in the number of combinations of the charge-discharge period, it is possible to adopt a specification in which an upper limit can be set for the number of interposed rest periods or the entire period of the charge-discharge period.

SOH calculator 113 calculates an SOH based on battery data of the calculation period that has been set (S12). SOH calculation value evaluation unit 114 evaluates reliability of the calculated SOH (S13). SOH calculator 113 weights the calculated SOH according to the reliability evaluated by SOH calculation value evaluation unit 114 (S14). When the weight of the SOH calculated from the battery data of the SOH calculation period including the discharge period is set to 0, only the SOH calculated from the battery data of the SOH calculation period not including the discharge period can be left as the basic data.

When the SOH calculation for the SOH calculation periods of all patterns meeting the setting condition is not finished (N in S15), the processing of steps S11 to S14 is repeated. When the SOH calculation for the SOH calculation periods of all patterns meeting the setting condition is finished (Y in S15), regression curve generator 115 performs curvilinear regression using the calculated sample data of the plurality of SOHs to generate a degradation regression curve of the cell or assembled battery 31 (S16). Lifetime prediction unit 116 predicts remaining lifetime of battery pack 30 based on the generated degradation regression curve (S17). The prediction of the remaining lifetime may be periodically updated by repeating the battery analysis processing described above, for example, every month.

As described above, according to the present exemplary embodiment, it is possible to improve analysis accuracy regarding the SOH. By including the SOH based on the battery data of the discharge period in the sample data, the number of pieces of sample data can be increased, and the accuracy of the degradation regression curve using the SOH can be improved. In addition, the period until the required number of pieces of sample data is collected can be shortened, and the generation timing of the degradation regression curve can be expedited. Further, the number of pieces of sample data can be further increased by including the SOH based on the battery data of the discharge period, the charge period, and the charge-discharge period that have the rest periods interposed therebetween in the sample data. In addition, by evaluating the reliability of the calculated SOH and weighting the SOH, it is possible to suppress a decrease in accuracy of the degradation regression curve due to inclusion of low quality sample data.

The present disclosure has been described above based on the exemplary embodiment. It is to be understood by the person of ordinary skill in the art that the exemplary embodiment is merely an example, that various modifications can be made by combining each configuration element and each processing process of the exemplary embodiment, and that such modifications are also within the scope of the present disclosure.

The function of battery analysis system 10 described above may be implemented in battery management device 32 of battery pack 30. When the function is implemented on battery pack 30 side, the accuracy of the integrated current of the discharging current or the charging current is improved, and thus the reliability of the SOH is increased accordingly. Conversely, when the function is implemented on the cloud side, the accuracy of the integrated current becomes relatively low, and thus the reliability evaluation of the SOH described above has greater importance.

In the above (Equation 3), a model in which the degradation of the secondary battery progresses in proportion to the square root of time (0.5 power law) is used. In this respect, a model in which the degradation of the secondary battery progresses in proportion to the square root of throughput [Ah] may be used.

The exemplary embodiment may be specified by the following items.

### [Item 1]

Battery analysis system (10) including:
data acquisition unit (111) configured to acquire battery data including a voltage and a current of secondary battery (E1-En);
SOH calculator (113) configured to calculate an SOH based on a current FCC of secondary battery (E1-En) and an initial FCC of secondary battery (E1-En), the current FCC being calculated based on an SOC difference and an integrated current over a period between a first rest state and a second rest state of the secondary battery, the SOC difference being determined based on a voltage in the first rest state of secondary battery (E1-En) and a voltage in the second rest state of secondary battery (E1-En), which are included in the battery data, and an SOC-OCV curve of secondary battery (E1-En); and
regression curve generator (115) configured to generate a degradation regression curve of secondary battery (E1-En) by performing curvilinear regression using sample data of a plurality of the SOHs that have been calculated, wherein
regression curve generator (115) applies, to each of the SOHs, a weight in a range of 0 to 1.

According to this, it is possible to improve analysis accuracy regarding the SOH.

### [Item 2]

Battery analysis system (10) according to the item 1, wherein
SOH calculator (113) calculates the SOH based on the battery data in a period including a discharge period between the first rest state and the second rest state.

According to this, it is possible to increase the number of pieces of sample data of the SOH.

### [Item 3]

Battery analysis system (10) according to the item 1, wherein
SOH calculator (113) calculates the SOH based on the battery data in a period including a plurality of discharge periods and at least one other rest state between the first rest state and the second rest state.

According to this, it is possible to further increase the number of pieces of sample data of the SOH.

### [Item 4]

Battery analysis system (10) according to the item 1, wherein
when the period between the first rest state and the second rest state is longer than a predetermined set time, SOH calculator (113) does not calculate the SOH based on the battery data in the period.

According to this, an increase in the number of pieces of sample data of the SOH can be limited. In addition, it is possible to prevent generation of sample data of an SOH whose influence of self-discharge is large.

### [Item 5]

Battery analysis system (10) according to the item 1, wherein
regression curve generator (115) changes the weight to each of the SOHs according to reliability of the SOH calculated by the SOH calculator (113).

According to this, a decrease in accuracy of the degradation regression curve due to inclusion of low quality sample data can be suppressed.

### [Item 6]

Battery analysis system (10) according to the item 5, wherein
regression curve generator (115) applies a larger weight to sample data of an SOH that is calculated from the battery data having a larger value of the SOC difference.

According to this, it is possible to reduce an influence of a low quality SOH.

### [Item 7]

Battery analysis system (10) according to the item 5, wherein
regression curve generator (115) applies a larger weight to sample data of an SOH that is calculated from the battery data in which a period of the first rest state or a period of the second rest state is longer.

According to this, it is possible to reduce an influence of a low quality SOH.

### [Item 8]

Battery analysis system (10) according to the item 5, wherein
the data acquisition unit acquires the battery data including a voltage, a current, and a temperature of secondary battery (E1-En), and
regression curve generator (115) applies a larger weight to sample data of an SOH that is calculated from the battery data including a higher temperature in the first rest state or in the second rest state.

According to this, it is possible to reduce an influence of a low quality SOH.

### [Item 9]

Battery analysis system (10) according to the item 5, wherein
regression curve generator (115) applies a larger weight to sample data of an SOH that is calculated from the battery data associated with a larger slope of the the SOC-OCV curve in an SOC range that includes an SOC obtained from the SOC-OCV curve using, as an OCV, the voltage in the first rest state or the voltage in the second rest state.

According to this, it is possible to reduce an influence of a low quality SOH.

### [Item 10]

Battery analysis system (10) according to the item 1, wherein
regression curve generator (115) applies, to zero, the weight to sample data of an SOH that is calculated from the battery data in a period including a discharge period.

According to this, it is possible to extract a SOH only from the battery data of the charge period.

### [Item 11]

A battery analysis method including:
acquiring battery data including a voltage and a current of secondary battery (E1-En);
calculating an SOH based on a current FCC of secondary battery (E1-En) and an initial FCC of secondary battery (E1-En), the current FCC being calculated based on an SOC difference and an integrated current over a period between a first rest state and a second rest state of the secondary battery, the SOC difference being determined based on a voltage in the first rest state of secondary battery (E1-En) and a voltage in the second rest state of secondary battery (E1-En), which are included the battery data, and an SOC-OCV curve of secondary battery (E1-En);
generating a degradation regression curve of secondary battery (E1-En) by performing curvilinear regression using sample data of a plurality of the SOHs that have been calculated; and
applying, to each of the SOHs, a weight in a range of 0 to 1.

According to this, it is possible to improve analysis accuracy regarding the SOH.

### [Item 12]

A battery analysis program causing a computer to perform processing steps including:
acquiring battery data including a voltage and a current of secondary battery (E1-En);
calculating an SOH based on a current FCC of secondary battery (E1-En) and an initial FCC of secondary battery (E1-En), the current FCC being calculated based on an SOC difference and an integrated current over a period between a first rest state and a second rest state of the secondary battery, the SOC difference being determined based on a voltage in the first rest state of secondary battery (E1-En) and a voltage in the second rest state of secondary battery (E1-En), which are included in the battery data, and an SOC-OCV curve of secondary battery (E1-En);
generating a degradation regression curve of secondary battery (E1-En) by performing curvilinear regression using sample data of a plurality of the SOHs that have been calculated; and
applying, to each of the SOHs, a weight in a range of 0 to 1.

According to this, it is possible to improve analysis accuracy regarding the SOH.

### REFERENCE MARKS IN THE DRAWINGS

1: electric bicycle
2: network
20: portable communication terminal
30: battery pack
31: assembled battery
32: battery management device
33: measurement unit
34: controller
35: wireless communication unit
35a: antenna
E10-En: cell
Rs: shunt resistor
T1: temperature sensor
SW1: switch
10: battery analysis system
11: controller
111: data acquisition unit
112: SOH calculation period set unit
113: SOH calculator
114: SOH calculation value evaluation unit
115: regression curve generator
116: lifetime prediction unit
12: storage unit
121: battery data holder
13: communication unit

## Claims

1. A battery analysis system comprising:
a data acquisition unit configured to acquire battery data including a voltage and a current of a secondary battery;
a State of Health (SOH) calculator configured to calculate an SOH based on a current Full Charge Capacity (FCC) of the secondary battery and an initial FCC of the secondary battery, the current FCC being calculated based on a State of Charge (SOC) difference and an integrated current over a period between a first rest state and a second rest state of the secondary battery, the SOC difference being determined based on a voltage in the first rest state and a voltage in the second rest state of the secondary battery, which are included in the battery data, and an SOC - Open Circuit Voltage (OCV) curve of the secondary battery; and
a regression curve generator configured to generate a degradation regression curve of the secondary battery by performing curvilinear regression using sample data of a plurality of the SOHs that have been calculated,
wherein the regression curve generator applies, to each of the SOHs, a weight in a range of 0 to 1.

2. The battery analysis system according to Claim 1,
wherein the SOH calculator calculates the SOH based on the battery data in a period including a discharge period between the first rest state and the second rest state.

3. The battery analysis system according to Claim 1,
wherein the SOH calculator calculates the SOH based on the battery data in a period including a plurality of discharge periods and at least one other rest state between the first rest state and the second rest state.

4. The battery analysis system according to Claim 1,
wherein when the period between the first rest state and the second rest state is longer than a predetermined set time, the SOH calculator does not calculate the SOH based on the battery data in the period.

5. The battery analysis system according to Claim 1,
wherein the regression curve generator changes the weight to each of the SOHs according to reliability of the SOH calculated by the SOH calculator.

6. The battery analysis system according to Claim 5,
wherein the regression curve generator applies a larger weight to sample data of an SOH that is calculated from the battery data having a larger value of the SOC difference.

7. The battery analysis system according to Claim 5,
wherein the regression curve generator applies a larger weight to sample data of an SOH that is calculated from the battery data in which a period of the first rest state or a period of the second rest state is longer.

8. The battery analysis system according to Claim 5,
wherein the data acquisition unit acquires the battery data including a voltage, a current, and a temperature of the secondary battery, and
the regression curve generator applies a larger weight to sample data of an SOH that is calculated from the battery data including a higher temperature in the first rest state or in the second rest state.

9. The battery analysis system according to Claim 5,
wherein the regression curve generator applies a larger weight to sample data of an SOH that is calculated from the battery data associated with a larger slope of the SOC-OCV curve in an SOC range that includes an SOC obtained from the SOC-OCV curve using, as an OCV, the voltage in the first rest state or the voltage in the second rest state.

10. The battery analysis system according to Claim 1,
wherein the regression curve generator applies, to zero, the weight to sample data of an SOH that is calculated from the battery data in a period including a discharge period.

11. A battery analysis method comprising:
acquiring battery data including a voltage and a current of a secondary battery;
calculating a State of Health (SOH) based on a current Full Charge Capacity (FCC) of the secondary battery and an initial FCC of the secondary battery, the current FCC being calculated based on a State of Charge (SOC) difference and an integrated current over a period between a first rest state and a second rest state of the secondary battery, the SOC difference being determined based on a voltage in the first rest state and a voltage in the second rest state of the secondary battery, which are included in the battery data, and an SOC - Open Circuit Voltage (OCV) curve of the secondary battery;
generating a degradation regression curve of the secondary battery by performing curvilinear regression using sample data of a plurality of the SOHs that have been calculated; and
applying, to each of the SOHs, a weight in a range of 0 to 1.

12. A battery analysis program causing a computer to perform processing steps comprising:
acquiring battery data including a voltage and a current of a secondary battery;
calculating a State of Health (SOH) based on a current Full Charge Capacity (FCC) of the secondary battery and an initial FCC of the secondary battery, the current FCC being calculated based on a State of Charge (SOC) difference and an integrated current over a period between a first rest state and a second rest state of the secondary battery, the SOC difference being determined based on a voltage in the first rest state and a voltage in the second rest state of the secondary battery, which are included in the battery data, and an SOC - Open Circuit Voltage (OCV) curve of the secondary battery;
generating a degradation regression curve of the secondary battery by performing curvilinear regression using sample data of a plurality of the SOHs that have been calculated; and
applying, to each of the SOHs, a weight in a range of 0 to 1.

13. A non-transitory recording medium containing the battery analysis program according to Claim 12.

14. A battery analysis system comprising:
a data acquisition unit configured to acquire battery data including a voltage and a current of a secondary battery, the secondary battery transitioning from a first rest state to a second rest state;
a State of Health (SOH) calculator configured to calculate an SOH based on a current Full Charge Capacity (FCC) of the secondary battery and an initial FCC of the secondary battery, the current FCC being calculated based on a State of Charge (SOC) difference and an integrated current over a period between the first rest state and the second rest state of the secondary battery, the SOC difference being determined based on a voltage in the first rest state of the secondary battery and a voltage in the second rest state of the secondary battery, which are included in the battery data, and an SOC - Open Circuit Voltage (OCV) curve of the secondary battery; and
a regression curve generator configured to generate a degradation regression curve of the secondary battery by performing curvilinear regression using sample data of a plurality of the SOHs that have been calculated in a time series,
wherein the regression curve generator applies, to each of the SOHs, a weight in a range of 0 to 1.
